(19) Europäisches Patentamt / European Patent Office / Office européen des brevets

(11) **EP 2 846 602 A1**

(12) # EUROPEAN PATENT APPLICATION
published in accordance with Art. 153(4) EPC

(43) Date of publication:
**11.03.2015 Bulletin 2015/11**

(51) Int Cl.:
***H04W 88/02*** (2009.01)

(21) Application number: **13784438.7**

(22) Date of filing: **06.03.2013**

(86) International application number:
**PCT/CN2013/072239**

(87) International publication number:
**WO 2013/163906 (07.11.2013 Gazette 2013/45)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **02.05.2012 CN 201210134523**

(71) Applicant: **Huizhou TCL Mobile Communication Co., Ltd.**
**Huizhou, Guangdong 516006 (CN)**

(72) Inventors:
• **BAI, Jian**
**Huizhou**
**Guangdong 516006 (CN)**

• **ZHANG, Lian**
**Huizhou**
**Guangdong 516006 (CN)**
• **XIE, Shengyin**
**Huizhou**
**Guangdong 516006 (CN)**
• **JIN, Xin**
**Huizhou**
**Guangdong 516006 (CN)**

(74) Representative: **D'Halleweyn, Nele Veerle Trees Gertrudis et al**
**Arnold & Siedsma**
**Bezuidenhoutseweg 57**
**2594 AC The Hague (NL)**

(54) **MOBILE COMMUNICATION TERMINAL**

(57) A mobile communication terminal is provided, which comprises: a first antenna, configured to receive a high-band radio frequency (RF) signal from the outside; a wireless transceiver, configured to acquire the high-band RF signal from the first antenna and generate a first base-band signal; a base-band processor, configured to acquire the first base-band signal from the wireless transceiver and modulate the first base-band signal, and further generate a second base-band signal and a third base-band signal; the wireless transceiver being further configured to convert the second base-band signal into a to-be-transmitted high-band RF signal and convert the third base-band signal into a to-be-transmitted low-band RF signal; a second antenna, configured to acquire and transmit the to-be-transmitted high-band RF signal and the to-be-transmitted low-band RF signal; wherein the second antenna is further configured to receive a low-band RF signal from the outside. In the aforesaid way, noises caused in the receiving frequency band by the transmitting path can be reduced, and the power consumption and the heat generation amount of the system can be further decreased. Meanwhile, the radio frequency architecture is simplified, and a low-cost and more compact space can be obtained.

FIG. 2

EP 2 846 602 A1

**Description**

FIELD OF THE INVENTION

The present disclosure relates to the technical field of the communication, and more particularly to a mobile communication terminal.

BACKGROUND OF THE INVENTION

Currently, the 3G (3rd-Generation)/4G (4th-Generation) FDD (Frequency Division Duplexing) mobile terminals adopt a full duplex design, so that the transmitting path and the receiving path thereof can operate simultaneously. In the conventional FDD radio frequency (RF) architecture, the duplexer is a kind of indispensable device and mainly has following functions:

    1) merging the transmitting path and the receiving path into a single path; and
    2) filtering the transmitting path and the receiving path.

The duplexers currently available have a large insertion loss (IL), and especially when the duplexers operate in a high frequency band and the transmitting frequency and the receiving frequency are close to each other, the insertion loss is very large. For example, the duplexer used in WCDMA BC2 (Wideband Code Division Multiple Access BC2) has an insertion loss of above 2.5dB. The main reason lies in that the transmitting frequency band is 1850MHz~1910MHz and the receiving frequency band is 1930MHz~1990MHz, and it is difficult to implement a band-pass filter that has a central frequency of 1950MHz and a transition bandwidth of only 20MHz.

Such the great insertion loss leads to the following problems:

    1) the problem of great power consumption. In case of the large insertion loss, the output power of the amplifier must be increased to ensure sufficient output power, and this will necessarily increase the power consumption.
    2) the problem of heat dissipation. As a result of the increased output power of the power amplifier and the increased power consumption, more heat will necessarily be generated. The heat generation amount of the power amplifiers in the conventional WCDMA terminals is very great, and this has an adverse effect on the battery and on the user experience.
    3) the cost problem. Devices with high design specifications will necessarily have an increased cost.

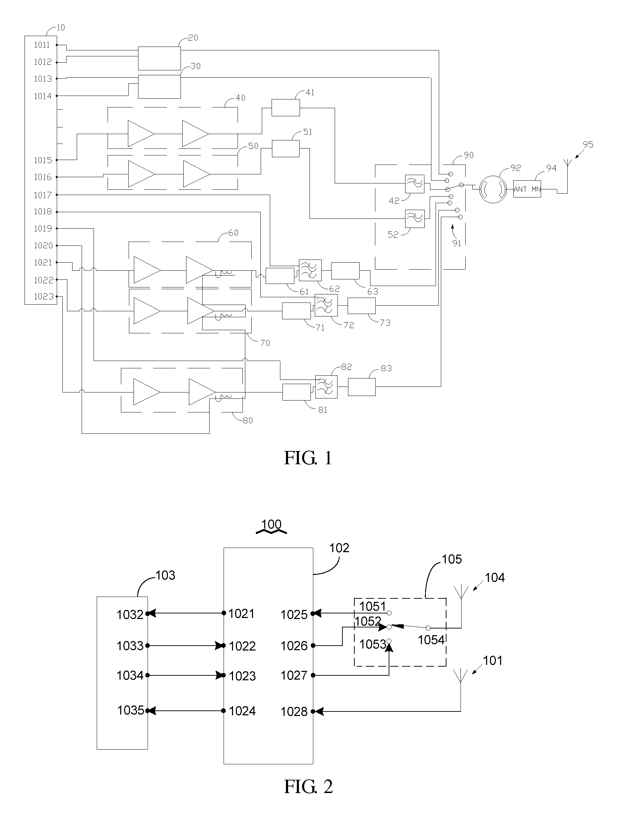

FIG. 1 shows a typical radio frequency (RF) framework of a WCDMA+GSM dual-mode terminal, which mainly comprises an antenna 95, a duplexer 90, a wireless transceiver 10, a plurality of signal receiving branches and a plurality of signal transmitting branches.

As two signal receiving branches, the GSM980/850 RX SAW module 20 and the DCS/PCS RX SAW module 30 are configured to receive RF signals that are acquired by the receiving antenna 95 and strobed by the duplexer 90. The wireless transceiver 10 acquires RF signals processed by the GSM980/850 RX SAW module 20 via ports 1011 and 1012, and acquires RF signals processed by the DCS/PCS RX SAW module 30 via ports 1013 and 1014.

The GSM HB PA (GSM High Band Power Amplifier) 40 and the HB MN (High Band Match Network) 41 form one GSM signal transmitting branch. GSM high-band signals transmitted by the wireless transceiver 10 via a port 1015 are transmitted to the GSM HB PA 40 and the HB MN 41, and the GSM HB PA 40 and the HB MN 41 perform the power amplification process and the network matching process on the GSM high-band signals respectively. Then, the processed GSM high-band signals are strobed by the duplexer 90 and then transmitted by the antenna 95.

The GSM LB PA (GSM Low Band Power Amplifier) 50 and the LB MN (Low Band Match Network) 51 form another GSM signal transmitting branch. GSM low-band signals transmitted by the wireless transceiver 10 via a port 1016 are transmitted to the GSM LB PA 50 and the LB MN 51, and the GSM LB PA 50 and the LB MN 51 perform the power amplification process and the network matching process on the GSM low-band signals respectively. Then, the processed GSM low-band signals are strobed by the duplexer 90 and then transmitted by the antenna 95.

The WCDMA BC1 PA (WCDMA Band Class 1 Power Amplifier) 60, W MN1 (WCDMA match network) 61, the duplexer 62 and the DPX MN (Duplexer Match Network) 63 form one WCDMA signal transmitting/receiving branch which is configured to transmit or receive WCDMA BC1 signals. Specifically, BC1 signals are transmitted by the wireless transceiver 10 via a port 1021, and the WCDMA BC1 PA 60, the W MN1 61 and the DPX MN 63 perform the power amplification process and the network matching process on the BC1 signals respectively. Then, the processed BC1 signals are strobed by the duplexer 90 and then transmitted by the antenna 95. The duplexer 62 may be used for selecting a path so that the BC1 signals transmitted by the wireless transceiver 10 via the port 1021 are transmitted to the outside via the antenna 95 or corresponding WCDMA signals are acquired from the antenna 95 via a port 1017.

Likewise, the wireless transceiver 10 generates WCDMA BC2 signals and WCDMA BC5 signals via a port 1022 and a port 1023 respectively, and acquires BC2 signals and BC 5 signals received by the antenna 95 from the outside via a port 1018 and a port 1019 respectively. Therefore, the port 1022 and the port 1023 correspond to two WCDMA signal transmitting branches respectively, and the port 1018 and the port 1019 correspond to two WCDMA signal receiving branches respectively. The WCDMA signal transmitting/receiving branches are completely same with the aforesaid WCDMA signal transmitting/receiving branches corresponding to the BC1 signals and thus, will not be further described herein.

Additionally, an RF connector 92 and an antenna match network (ANT MN) 94 are further disposed between the antenna and the duplexer 90, to couple signals from different signal sources and to perform the antenna matching process on the signals respectively.

In the conventional mobile communication terminal, the duplexer 90 is mainly used to:

1) merge the transmitting path and the receiving path into a single path; and

2) provide the isolation between the transmitting path and the receiving path, i.e., attenuate noises of the RF signals of the transmitting path in the receiving frequency band so as to prevent interfering with the received signal.

The reason of providing the isolation between the transmitting path and the receiving path is as follows: the receiving path is required to have a high sensitivity (the typical value is -110dBm), and the transmitting path is a high-power path with a strength of up to 28dBm. Because of the nonlinear nature of the RF system, there will necessarily be strong out-of-band stray signals when the main wave is 28dBm. If these out-of-band stray signals are not isolated in the receiving frequency band but are directly fed into the receiving end, the strength thereof will exceed that of the useful receive signals and it will affect the receiving performance.

Next, the following will analyze the design of the WCDMA signal receiving system of the mobile communication terminal shown in FIG. 1.

The typical receiving sensitivity of a conventional WCDMA terminal is -110dBm.

The power of DPDCH (Dedicated Physical Data Channel) is -120.3dBm.

The channel for WCDMA sensitivity testing has a coding rate of 12.2kbps and a coding gain of $10 \times \log(3.84\text{MHz}/12.2) = 25\text{dB}$.

The decoding threshold of the QPSK modulation scheme for WCDMA is 5.2dB and a preset margin of 2dB is required, so the input signal to noise ratio (SNR) of the demodulation module is required to be 7.2dB.

Therefore, the noise at the input terminal of the demodulation module shall be lower than:

$$-120.3 + 25 - 7.2 = -102.5 \text{ dBm}/3.84\text{MHz} = -168.343\text{dBm/Hz}$$

Considering that the noise index of the wireless transceiver 10 is typically 5dB, the noise at the input terminal of the demodulation module shall be lower than -173.343 dBm/Hz.

The system thermal noise is:

$$KBT = -200 + 26.022 = -173.977\text{dBm/Hz} = -108.13\text{dBm}/3.84\text{MHz}$$

where K(Boltzmann constant) =1.38x10-20mJ/K, B=3.84MHz (65.843dB), T=290 K.

The output noise of the typical power amplifier (60, 70, 80) is:

-160dBm/Hz(output of the wireless transceiver)+28dB (typical amplification gain of the amplifier in the receiving frequency band)=-132dBm/Hz = -66.16 dBm/3.84MHz.

Therefore, an isolation degree of at least 173.343-132= 41dB needs to be provided by the duplexer 90.

Because such the great isolation degree is provided, the conventional duplexer has a relatively large insertion loss.

The conventional methods generally increase the power to decrease the insertion loss, but as the power increases, the power consumption of the system is increased and, correspondingly, the heat generation amount is relatively high.

Accordingly, there is a need to provide an antenna modulation method for a mobile communication terminal, to solve the aforesaid problems.

## SUMMARY OF THE INVENTION

To solve the aforesaid technical problem, the present disclosure provides a mobile communication terminal to solve the technical problem that the insertion loss of the convention duplexer is relatively large.

To solve the aforesaid technical problem, a technical solution adopted by the present disclosure is to provide a mobile communication terminal. The mobile communication terminal comprises: a first antenna, being configured to receive a high-band radio frequency (RF) signal from the outside; a wireless transceiver, being configured to acquire the high-band RF signal from the first antenna and generate a first base-band signal according to the high-band RF signal; a base-band processor, being configured to acquire the first base-band signal from the wireless transceiver and modulate the first base-band signal, and further generate a second base-band signal and a third base-band signal for transmission to the wireless transceiver; the wireless transceiver being further configured to convert the second base-band signal into a to-be-transmitted high-band RF signal and convert the third base-band signal into a to-be-transmitted low-band RF signal; a second antenna, being configured to acquire from the wireless transceiver and transmit the to-be-transmitted high-band RF signal and the to-be-transmitted low-band RF signal; wherein the second antenna is further configured to receive a low-band RF signal from the outside, the wireless transceiver is configured to acquire the low-band RF signal from the second antenna and generate a fourth base-band signal according to the low-band RF signal, and the base-band processor is configured to acquire the fourth base-band signal from the wireless transceiver and modulate the fourth base-band signal; a high-band RF signal power amplifier, being disposed between the second antenna and the wireless transceiver and configured to amplify the power of the to-be-transmitted high-band RF signal generated by the wireless transceiver; and a low-band RF signal power amplifier, being disposed between the second antenna and the wireless transceiver and configured to amplify the power of the to-be-transmitted low-band RF signal generated by the wireless transceiver.

Preferably, the high-band RF signal comprises a BC1 signal and a BC4 signal, the low-band RF signal comprises a GSM HB signal and a GSM LB signal, the to-be-transmitted high-band RF signal comprises a BC1/BC4 signal and a BC2 signal, and the to-be-transmitted low-band RF signal comprises a to-be-transmitted GSM HB signal, a to-be-transmitted GSM LB signal and a to-be-transmitted BC5/BC8 signal.

Preferably, the mobile communication terminal further comprises: a high-band RF signal reception surface acoustic wave (SAW) filter, being disposed between the first antenna and the wireless transceiver and configured to perform a reception SAW filtering process on the high-band RF signal received by the first antenna; and a low-band RF signal reception SAW filter, being disposed between the second antenna and the wireless transceiver and configured to perform the reception SAW filtering process on the low-band RF signal received by the second antenna.

To solve the aforesaid technical problem, another technical solution adopted by the present disclosure is to provide a mobile communication terminal. The mobile communication terminal comprises: a first antenna, being configured to receive a high-band radio frequency (RF) signal from the outside; a wireless transceiver, being configured to acquire the high-band RF signal from the first antenna and generate a first base-band signal according to the high-band RF signal; a base-band processor, being configured to acquire the first base-band signal from the wireless transceiver and modulate the first base-band signal, and further generate a second base-band signal and a third base-band signal for transmission to the wireless transceiver; the wireless transceiver being further configured to convert the second base-band signal into a to-be-transmitted high-band RF signal and convert the third base-band signal into a to-be-transmitted low-band RF signal; a second antenna, being configured to acquire from the wireless transceiver and transmit the to-be-transmitted high-band RF signal and the to-be-transmitted low-band RF signal; wherein the second antenna is further configured to receive a low-band RF signal from the outside, the wireless transceiver is configured to acquire the low-band RF signal from the second antenna and generate a fourth base-band signal according to the low-band RF signal, and the base-band processor is configured to acquire the fourth base-band signal from the wireless transceiver and modulate the fourth base-band signal.

Preferably, the high-band RF signal comprises a BC1 signal and a BC4 signal, the low-band RF signal comprises a GSM HB signal and a GSM LB signal, the to-be-transmitted high-band RF signal comprises a BC1/BC4 signal and a BC2 signal, and the to-be-transmitted low-band RF signal comprises a to-be-transmitted GSM HB signal, a to-be-transmitted GSM LB signal and a to-be-transmitted BC5/BC8 signal.

Preferably, the mobile communication terminal further comprises: a high-band RF signal reception surface acoustic wave (SAW) filter, being disposed between the first antenna and the wireless transceiver and configured to perform a reception SAW filtering process on the high-band RF signal received by the first antenna; and a low-band RF signal reception SAW filter, being disposed between the second antenna and the wireless transceiver and configured to perform the reception SAW filtering process on the low-band RF signal received by the second antenna.

Preferably, the mobile communication terminal further comprises: a high-band RF signal power amplifier, being disposed between the second antenna and the wireless transceiver and configured to amplify the power of the to-be-transmitted high-band RF signal generated by the wireless transceiver.

Preferably, the mobile communication terminal further comprises: a low-band RF signal power amplifier, being disposed between the second antenna and the wireless transceiver and configured to amplify the power of the to-be-transmitted low-band RF signal generated by the wireless transceiver.

To solve the aforesaid technical problem, yet another technical solution adopted by the present disclosure is to provide a mobile communication terminal. The mobile communication terminal comprises: a first antenna, being configured to receive a high-band radio frequency (RF) signal and a low-band RF signal from the outside; a wireless transceiver, being configured to acquire the high-band RF signal from the first antenna and generate a first base-band signal according to the high-band RF signal, and being configured to acquire the low-band RF signal from the first antenna and generate a second base-band signal according to the low-band RF signal; a base-band processor, being configured to acquire the first base-band signal and the second base-band signal from the wireless transceiver and modulate the first base-band signal and the second base-band signal, and further generate a third base-band signal and a fourth base-band signal for transmission to the wireless transceiver; the wireless transceiver being further configured to convert the third base-band signal into a to-be-transmitted high-band RF signal and convert the fourth base-band signal into a to-be-transmitted low-band RF signal; a second antenna, being configured to acquire from the wireless transceiver and transmit the to-be-transmitted high-band RF signal; wherein the first antenna is further configured to acquire from the wireless transceiver and transmit the to-be-transmitted low-band RF signal.

Preferably, the high-band RF signal comprises a BC1/BC4 signal, the low-band RF signal comprises a GSM 900/850 signal, a GSM DCS signal and a BC5/BC8 signal, the to-be-transmitted high-band RF signal comprises a BC1/BC4 signal and a BC2 signal, and the to-be-transmitted low-band RF signal comprises a to-be-transmitted GSM HB signal, a to-be-transmitted GSM LB signal and a to-be-transmitted BC5/BC8 signal.

Preferably, the mobile communication terminal further comprises: a high-band RF signal reception surface acoustic wave (SAW) filter, being disposed between the first antenna and the wireless transceiver and configured to perform a reception SAW filtering process on the high-band RF signal received by the first antenna; and a low-band RF signal reception SAW filter, being disposed between the first antenna and the wireless transceiver and configured to perform the reception SAW filtering process on the low-band RF signal received by the first antenna.

Preferably, the mobile communication terminal further comprises: a high-band RF signal power amplifier, being disposed between the second antenna and the wireless transceiver and configured to amplify the power of the to-be-transmitted high-band RF signal generated by the wireless transceiver.

Preferably, the mobile communication terminal further comprises: a low-band RF signal power amplifier, being disposed between the first antenna and the wireless transceiver and configured to amplify the power of the to-be-transmitted low-band RF signal generated by the wireless transceiver.

As compared to the prior art, the benefits of the present disclosure are as follows: the technical solution provided by the present disclosure disposes a first antenna and a second antenna, enables the first antenna to receive a high-band RF signal from the outside, enables the second antenna to transmit a to-be-transmitted high-band RF signal and a to-be-transmitted low-band RF signal, and enables the second antenna to receive a low-band RF signal. Accordingly, a high-frequency duplexer is omitted, so the insertion loss problem caused by the high-frequency duplexer is solved and, correspondingly, noises caused in the receiving frequency band by the transmitting path is reduced; and furthermore, the power consumption and the heat generation amount of the system are further decreased. Meanwhile, the radio frequency (RF) architecture is simplified, and a low-cost and more compact space can be obtained. The present disclosure is especially suitable for a platform having a relatively low output power.

BRIEF DESCRIPTION OF THE DRAWINGS

FIG. 1 is a circuit diagram illustrating the operating principle of a radio frequency (RF) signal transceiving circuit of a mobile communication terminal of the prior art;
FIG. 2 is a circuit diagram illustrating the operating principle of an RF signal transceiving circuit of a mobile communication terminal according to a first embodiment of the present disclosure;
FIG. 3 is a circuit diagram illustrating the operating principle of an RF signal transceiving circuit of a mobile communication terminal according to a second embodiment of the present disclosure;
FIG. 4 is a circuit diagram illustrating the operating principle of an RF signal transceiving circuit of a mobile communication terminal according to a third embodiment of the present disclosure;
FIG. 5 is a circuit diagram illustrating the operating principle of an RF signal transceiving circuit of a mobile communication terminal according to a fourth embodiment of the present disclosure;
FIG. 6 is a partial schematic structural view illustrating the appearance of a first antenna of the mobile communication terminal according to the second embodiment of the present disclosure; and
FIG. 7 is a graph illustrating the isolation degree between the transmitting path and receiving path of the first antenna of the mobile communication terminal according to the second embodiment of the present disclosure.

DETAILED DESCRIPTION OF THE INVENTION

Referring to FIG. 2, FIG. 2 is a circuit diagram illustrating the operating principle of an RF signal transceiving circuit of a mobile communication terminal according to a first embodiment of the present disclosure. As shown in FIG. 2, the mobile communication terminal 100 of the present disclosure comprises: a first antenna 101, a wireless transceiver 102, a base-band processor 103, a second antenna 104 and a control switch 105, and these modules form an RF signal transceiving circuit. The first antenna 101 is configured to receive a high-band RF signal from the outside. The wireless transceiver 102 is configured to acquire the high-band RF signal received by the first antenna 101 via a port 1028, generate a first base-band signal according to the high-band RF signal and output the first base-band signal via a port 1024. The base-band processor 103 is configured to acquire the first base-band signal output by the port 1024 from a port 1035 and modulate the first base-band signal, and further generate a second base-band signal and a third base-band signal. The second base-band signal is output from a port 1034, and the third base-band signal is output form a port 1033. The wireless transceiver 102 is configured to receive the second base-band signal output by the port 1034 of the base-band processor 103 from a port 1023, and further convert the second base-band signal into a to-be-transmitted high-band RF signal. When a fixed terminal 1054 of the control switch 105 is connected with a port 1053, the second antenna 104 is configured to acquire the to-be-transmitted high-band RF signal from a port 1027 of the wireless transceiver 102 via the control switch 105 and transmit the to-be-transmitted high-band RF signal. The wireless transceiver 102 is further configured to receive the third base-band signal output by the port 1033 of the base-band processor 103 from a port 1022, and further convert the third base-band signal into a to-be-transmitted low-band RF signal. When the fixed terminal 1054 of the control switch 105 is connected with a port 1052, the second antenna 104 is configured to acquire the to-be-transmitted low-band RF signal from a port 1026 of the wireless transceiver 102 via the control switch 105 and transmit the to-be-transmitted low-band RF signal. The second antenna 104 is further configured to receive a low-band RF signal from the outside. When the fixed terminal 1054 of the control switch 105 is connected with a port 1051, the wireless transceiver 102 acquires the low-band RF signal received by the second antenna 104 from a port 1025 and further generates a fourth base-band signal according to the low-band RF signal, and outputs the fourth base-band signal from a port 1021. A port 1032 of the base-band processor 103 acquires the fourth base-band signal from the port 1021 and modulates the fourth base-band signal.

In a preferred embodiment, the high-band RF signal comprises a BC1 signal and a BC4 signal, the low-band RF signal comprises a GSM HB signal and a GSM LB signal, the to-be-transmitted high-band RF signal comprises a BC1/BC4 signal and a BC2 signal, and the to-be-transmitted low-band RF signal comprises a to-be-transmitted GSM HB signal, a to-be-transmitted GSM LB signal and a to-be-transmitted BC5/BC8 signal.

In a preferred embodiment, the mobile communication terminal 100 further comprises a high-band RF signal reception surface acoustic wave (SAW) filter and a low-band RF signal reception SAW filter. The high-band RF signal reception SAW filter is disposed between the first antenna 101 and the wireless transceiver 102, and configured to perform a reception SAW filtering process on the high-band RF signal received by the first antenna 101. The low-band RF signal reception SAW filter is disposed between the second antenna 104 and the wireless transceiver 102 and configured to perform the reception SAW filtering process on the low-band RF signal received by the second antenna 104.

In a preferred embodiment, the mobile communication terminal 100 further comprises a high-band RF signal power amplifier and a low-band RF signal power amplifier. The high-band RF signal power amplifier is disposed between the second antenna 104 and the wireless transceiver 102 and configured to amplify the power of the to-be-transmitted high-band RF signal generated by the wireless transceiver 102. The low-band RF signal power amplifier is disposed between the second antenna 104 and the wireless transceiver 102 and configured to amplify the power of the to-be-transmitted low-band RF signal generated by the wireless transceiver 102.

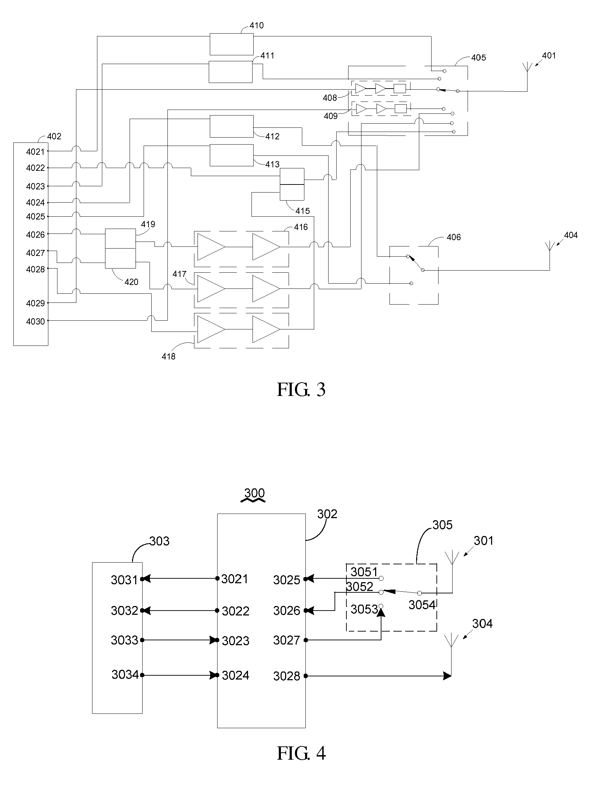

Please refer to FIG. 3 which shows specific configuration of the high-band RF signal reception SAW filter, the low-band RF signal reception SAW filter, the high-band RF signal power amplifier, and the low-band RF signal power amplifier described above.

Referring to FIG. 3, FIG. 3 is a circuit diagram illustrating the operating principle of an RF signal transceiving circuit of a mobile communication terminal according to a second embodiment of the present disclosure. As shown in FIG. 3, the second embodiment of present disclosure further extends types of RF signals and paths thereof according to the practical applications on the basis of the first embodiment, so as to meet the needs of GSM/WCDMA dual-mode communication. High-band RF signals have two transceiving paths. A first antenna 404, a first control switch 406, a first high-band RF signal reception SAW filter 413, a wireless transceiver 402, a first high-band RF signal transmitting filter 419, a first high-band RF signal power amplifier 416, a third low-band RF signal power amplifier 418, a second control switch 405 and a second antenna 401 form the transceiving path of the first high-band RF signal which is configured to receive and transmit the first high-band RF signal. In detail, the first antenna 404 is configured to receive a first high-band RF signal from the outside, and transmit the first high-band RF signal to the first high-band RF signal reception SAW filter 413 for filtering after being strobed via the first control switch 406. The transceiver 402 is configured to receive the filtered first high-band RF signal from a port 4025, generate a first base-band signal according to the first high-band RF signal and output the first base-band signal to the base-band processor (not shown). The base-band processor is configured to acquire the first base-band signal output by the wireless transceiver 402 and modulate the first base-band signal, and further generate a second base-band signal and a third base-band signal. The wireless transceiver 402 is configured to receive the second base-band signal and the third base-band signal, convert the second base-band signal into a first to-be-transmitted high-band RF signal, and transmit the first to-be-transmitted high-band RF signal via a port 4026. The first high-band RF signal transmitting filter 419 and the first high-band RF signal power amplifier 416 perform the filtering process and the power amplification process on the first to-be-transmitted high-band RF signal respectively. The processed first to-be-transmitted high-band RF signal is transmitted via the second antenna 401 after being strobed by the second control switch 405. Likewise, the wireless transceiver 402 is configured to convert the third base-band signal into a third to-be-transmitted low-band RF signal, and then transmit the third to-be-transmitted low-band RF signal via a port 4028. The third low-band RF signal power amplifier 418 is configured to amplify the power of the third to-be-transmitted low-band RF signal, and the processed third to-be-transmitted low-band RF signal is transmitted via the second antenna 401 after being strobed by the second control switch 405. A duplexer 415 may be used to select a path so that the wireless transceiver 402 can receive the third low-band RF signal via a port 4022 and can also transmit the third to-be-transmitted low-band RF signal via a port 4028.

Likewise, the transceiving principle of the second high-band RF signal is the same as that of the first high-band RF signal, and the architectures of the transceiving paths of the second high-band RF signal and the first high-band RF signal are completely same. Differences lie in that: the wireless transceiver 402 is configured to receive the second high-band RF signal output by a second high-band RF signal reception SAW filter 412 from a port 4024, and output the corresponding second to-be-transmitted high-band RF signal via a port 4027 after the second high-band RF signal is converted by the base-band processor; and a second high-band RF signal transmitting filter 420 and a second high-band RF signal power amplifier 417 filter and amplify the second to-be-transmitted high-band RF signal respectively.

In a preferred embodiment, the second antenna 401 is further configured to receive a low-band RF signal from the outside. The second antenna 401, the second control switch 405, a first low-band RF signal reception SAW filter 410, the wireless transceiver 402 and a first low-band RF signal power amplifier 409 form the transceiving path of the first low-band RF signal which is configured to receive and transmit the first low-band RF signal. In detail, the second antenna 401 is configured to receive a first low-band RF signal from the outside, and transmit the first low-band RF signal to the first low-band RF signal reception SAW filter 410 for filtering after being strobed by the second control switch 405. The transceiver 402 is configured to receive the filtered first low-band RF signal from a port 4021, generate a fourth base-band signal according to the first low-band RF signal and output the fourth base-band signal to the base-band processor (not shown). The base-band processor is configured to acquire the fourth base-band signal output from the wireless transceiver 402 and modulate the fourth base-band signal. The wireless transceiver 402 is further configured to convert the signal modulated by the base-band processor into a first to-be-transmitted low-band RF signal and transmit the first to-be-transmitted low-band RF signal via a port 4030. The first to-be-transmitted low-band RF signal is amplified by the first low-band RF signal power amplifier 409 and then transmitted by the second antenna 401 after being strobed by the second antenna 405.

Likewise, the transceiving principle of the second low-band RF signal is the same as that of the first low-band RF signal, and the architectures of the transceiving paths of the second low-band RF signal and the first low-band RF signal are completely same. Differences lie in that: the wireless transceiver 402 is configured to receive the second low-band RF signal output by a second low-band RF signal reception SAW filter 411 from a port 4023, and output the corresponding second to-be-transmitted low-band RF signal via a port 4029 after the second low-band RF signal is converted by the base-band processor; and then the second to-be-transmitted low-band RF signal is amplified by a second low-band RF signal power amplifier 408.

In a preferred embodiment, the first high-band RF signal and the second high-band RF signal comprise a BC1 signal and a BC4 signal, the first low-band RF signal and the second low-band RF signal comprise a GSM LB signal and a GSM HBG signal, the first to-be-transmitted high-band RF signal and the second to-be-transmitted high-band RF signal comprise a BC1/BC4 signal and a BC2 signal, and the first to-be-transmitted low-band RF signal, the second to-be-transmitted low-band RF signal and the third to-be-transmitted low-band RF signal comprise a GSM HB signal, a to-be-transmitted GSM LB signal and a to-be-transmitted BC5/BC8 signal.

Referring to FIG. 4, FIG. 4 is a circuit diagram illustrating the operating principle of an RF signal transceiving circuit of a mobile communication terminal according to a third embodiment of the present disclosure. As shown in FIG. 4, the mobile communication terminal 300 of the present disclosure comprises a first antenna 301, a wireless transceiver 302, a base-band processor 303, a second antenna 304 and a control switch 305, and these modules form the RF signal transceiving circuit.

In this embodiment, the first antenna 301 is configured to receive a high-band RF signal from the outside. In detail, when a fixed terminal 3054 of the control switch 305 is connected with a port 3051, the wireless transceiver 302 acquires the high-band RF signal received by the first antenna 301 from a port 3025. The wireless transceiver 302 is configured to generate a first base-band signal according to the high-band RF signal and output the first base-band signal from a port 3021 to the base-band processor 303. The base-band processor 303 is configured to acquire the first base-band signal output from the port 3021 via a port 3031 and modulate the first base-band signal, and further generate a third base-band signal so as to transmit the third base-band signal from a port 3034 to the wireless transceiver 302. The wireless transceiver 302 is configured to receive the third base-band signal output from the port 3034 via a port 3024, further convert the third base-band signal into a to-be-transmitted high-band RF signal, and output the to-be-transmitted high-band RF signal to the second antenna 304 via a port 3028. The second antenna 304 is configured to transmit the to-be-transmitted high-band RF signal.

In this embodiment, the first antenna 301 is further configured to receive a low-band RF signal from the outside and transmit a to-be-transmitted low-band RF signal. In detail, when the fixed terminal 3054 of the control switch 305 is connected with a port 3052, the wireless transceiver 302 acquires the low-band RF signal received by the first antenna 301 from a port 3026. The wireless transceiver 302 is configured to generate a second base-band signal according to the low-band RF signal and output the second base-band signal from a port 3022 to the base-band processor 303. The base-band processor 303 is configured to acquire the second base-band signal output from the port 3022 via a port 3032 and modulate the second base-band signal, and further generate a fourth base-band signal so as to transmit the fourth base-band signal from a port 3033 to the wireless transceiver 302. The wireless transceiver 302 is configured to receive the fourth base-band signal output from the port 3033 via a port 3023, further convert the fourth base-band signal into a to-be-transmitted low-band RF signal, and output the to-be-transmitted low-band RF signal to the first antenna 301 via a port 3027 when the fixed terminal 3054 of the control switch 305 is connected with a port 3053. The first antenna 301 is configured to transmit the to-be-transmitted low-band RF signal.

In a preferred embodiment, the high-band RF signal comprises a BC1/BC4 signal, the low-band RF signal comprises a GSM 900/850 signal, a GSM DCS signal and a BC5/BC8 signal, the to-be-transmitted high-band RF signal comprises a BC1/BC4 signal and a BC2 signal, and the to-be-transmitted low-band RF signal comprises a to-be-transmitted GSM HB signal, a to-be-transmitted GSM LB signal and a to-be-transmitted BC5/BC8 signal.

In a preferred embodiment, the mobile communication terminal 300 further comprises a high-band RF signal reception surface acoustic wave (SAW) filter and a low-band RF signal reception SAW filter. The high-band RF signal reception SAW filter is disposed between the first antenna 301 and the wireless transceiver 302 and configured to perform a reception SAW filtering process on the high-band RF signal received by the first antenna 301. The low-band RF signal reception SAW filter is disposed between the first antenna 301 and the wireless transceiver 302 and configured to perform the reception SAW filtering process on the low-band RF signal received by the first antenna 301.

In a preferred embodiment, the mobile communication terminal 300 further comprises a high-band RF signal power amplifier and a low-band RF signal power amplifier. The high-band RF signal power amplifier is disposed between the second antenna 304 and the wireless transceiver 302 and configured to amplify the power of the to-be-transmitted high-band RF signal generated by the wireless transceiver 302. The low-band RF signal power amplifier is disposed between the first antenna 301 and the wireless transceiver 302 and configured to amplify the power of the to-be-transmitted low-band RF signal generated by the wireless transceiver 302.

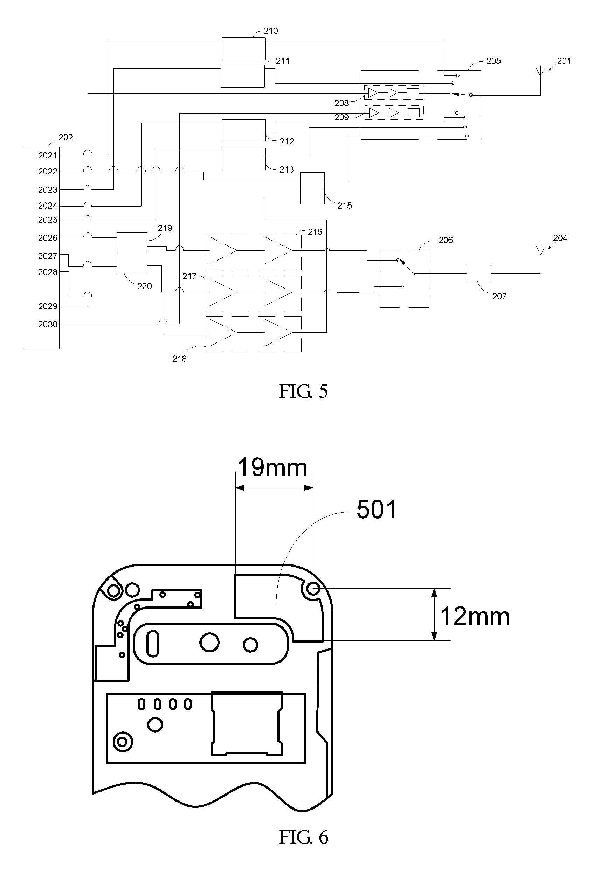

Please refer to FIG. 5 which shows specific configuration of the high-band RF signal reception SAW filter, the low-band RF signal reception SAW filter, the high-band RF signal power amplifier, and the low-band RF signal power amplifier described above.

Referring to FIG. 5, FIG. 5 is a circuit diagram illustrating the operating principle of an RF signal transceiving circuit of a mobile communication terminal according to a fourth embodiment of the present disclosure. As shown in FIG. 5, the fourth embodiment of present disclosure further extends types of RF signals and paths thereof according to the practical applications on the basis of the third embodiment, so as to meet the needs of GSM/WCDMA dual-mode communication. High-band RF signals have two transceiving paths. A first antenna 201, a first control switch 205, a first high-band RF signal reception SAW filter 212, a wireless transceiver 202, a first high-band RF signal transmitting filter 220, a first high-band RF signal power amplifier 217, a second control switch 206, a transmitting filter 207, and a second antenna 204 form the transceiving path of the first high-band RF signal which is configured to receive and transmit the first high-band RF signal. Specifically, the first antenna 201 is configured to receive a first high-band RF signal from the outside, and transmit the first high-band RF signal to the first high-band RF signal reception SAW filter 212 for filtering after being strobed via the first control switch 205. The transceiver 202 is configured to receive the filtered first high-band RF signal from a port 2024, generate a first base-band signal according to the first high-band RF signal and output the first base-band signal to the base-band processor (not shown). The base-band processor is configured to acquire the first base-band signal output by the wireless transceiver 202 and modulate the first base-band signal, and further generate a third base-band signal. The wireless transceiver 202 is configured to receive the third base-band signal, convert the third base-band signal into a first to-be-transmitted high-band RF signal, and transmit the first to-be-transmitted high-band RF signal via a port 2027. The first high-band RF signal transmitting filter 220 and the first high-band RF signal power amplifier 217 perform filtering and power amplification on the first to-be-transmitted high-band RF signal respectively. The processed first to-be-transmitted high-band RF signal is strobed by the second control switch 206 and filtered by the transmitting filter 207, and is then transmitted via the second antenna 204.

Likewise, the transceiving principle of the second high-band RF signal is the same as that of the first high-band RF signal, and the architectures of the transceiving paths of the second high-band RF signal and the first high-band RF signal are completely the same. Differences lie in that: the wireless transceiver 202 is configured to receive the second high-band RF signal output by a second high-band RF signal reception SAW filter 213 via a port 2025, and output the corresponding second to-be-transmitted high-band RF signal via a port 2026 after the second high-band RF signal is converted by the base-band processor; and the second to-be-transmitted high-band RF signal is filtered and amplified by a second high-band RF signal transmitting filter 219 and a second high-band RF signal power amplifier 216 respectively.

In a preferred embodiment, the first antenna 201 is further configured to acquire from the wireless transceiver 202 and transmit the to-be-transmitted low-band RF signal. The low-band RF signals have three transceiving paths. The first antenna 201, the first control switch 205, a first low-band RF signal reception SAW filter 210, the wireless transceiver 202, and a first low-band RF signal power amplifier 209 form the transceiving path of the first low-band RF signal which is configured to receive and transmit the first low-band RF signal. Specifically, the first antenna 201 is configured to receive a first low-band RF signal from the outside, and transmit the first low-band RF signal to the first low-band RF signal reception SAW filter 210 for filtering after being strobed via the first control switch 205. The transceiver 202 is configured to receive the filtered first low-band RF signal from a port 2021, generate a second base-band signal according to the first low-band RF signal and output the second base-band signal to the base-band processor (not shown). The base-band processor is configured to acquire the second base-band signal output by the wireless transceiver 202 and modulate the second base-band signal, and further generate a fourth base-band signal. The wireless transceiver 202 is further configured to convert the fourth base-band signal into a first to-be-transmitted low-band RF signal, and transmit the first to-be-transmitted low-band RF signal via a port 2030. The first to-be-transmitted low-band RF signal is amplified by the first low-band RF signal power amplifier 209 and then transmitted by the first antenna 201 after being strobed by the first control switch 205.

Likewise, the transceiving principle of the second low-band RF signal is the same as that of the first low-band RF signal, and the architectures of the transceiving paths of the second low-band RF signal and the first low-band RF signal are completely the same. Differences lie in that: the wireless transceiver 202 is configured to receive the second low-band RF signal output by a second low-band RF signal reception SAW filter 211 via a port 2023, and output the corresponding second to-be-transmitted low-band RF signal via a port 2029 after the second low-band RF signal is converted by the base-band processor; and then the second to-be-transmitted low-band RF signal is amplified by a second low-band RF signal power amplifier 208.

In a preferred embodiment, the first antenna 201, the first control switch 205, the wireless transceiver 202, a duplexer 215, and a third low-band RF signal power amplifier 218 form the transceiving path of a third low-band RF signal. The duplexer 215 is configured to select a path so that after strobing of the first control switch 205, the wireless transceiver 202 can receive the third low-band RF signal, which is acquired from the first antenna 201, from the duplexer 215 via a port 2022 and transmit the third low-band RF signal to the base-band processor for modulation. The third low-band RF signal is further converted into a third to-be-transmitted low-band RF signal by the wireless transceiver 202, and transmitted via a port 2028 to the third low-band RF signal power amplifier 218 for amplification. After being strobed by the first control switch 205, the third to-be-transmitted low-band RF signal is transmitted to the first antenna 201 via the duplexer 215, and then transmitted to the outside by the first antenna 201.

In a preferred embodiment, the first high-band RF signal and the second high-band RF signal comprise a BC1/BC4 signal; the first low-band RF signal, the second low-band RF signal and the third low-band RF signal comprise a GSM 900/850 signal, a GSM DCS signal and a BC5/BC8 signal; the first to-be-transmitted high-band RF signal and the second to-be-transmitted high-band RF signal comprise a BC1/BC4 signal and a BC2 signal; and the first to-be-transmitted low-band RF signal, the second to-be-transmitted low-band RF signal, and the third to-be-transmitted low-band RF signal comprise a to-be-transmitted GSM HB signal, a to-be-transmitted GSM LB signal and a to-be-transmitted BC5/BC8 signal.

In the present disclosure, the high-band receiving antenna is used for 3G/4G high-band receiving. Generally, the main antenna is disposed right at the back of the mobile phone. According to the circuit diagram illustrating the operating principle of the RF signal transceiving circuit of the mobile communication terminal as shown in FIG. 1, the 3G/4G high-frequency transmitting antenna must be located at the front of the mobile phone to provide a sufficient isolation degree. However, this would result in excessively high SAR (Specific Absorption Rate) and HAC (Hearing Auxiliary Compatibility).

In FIG. 2 to FIG. 5, 3G/4G signals are received via an SPDT (Single Pole Double Throw) switch. To meet the requirement of the isolation degree between the main antenna and the high-frequency receiving antenna, the present disclosure simulates the architecture of the RF antenna signal transceiving circuit of the mobile communication terminal shown in FIG. 2 to FIG. 5, and measures noises in the receiving frequency band of the current 3G power amplifier chip. Because the transmitting frequency band of the BC2 is between 1850MHz and 1910MHz and the receiving frequency band thereof is between 1930MHz and 1990MHz, the transmitting frequency band and the receiving frequency band are close to each other and the noise performance thereof is relatively poor. Thus, the power amplifier of the BC2 is selected for measurement, and the measurement result is as shown in Table 1.

Table 1:

| Board | Tx Freq (MHz) | Vcc (V) | RxNP (dBm/Hz) vs.Pout (dBm) | | | | | |
| | | | RFMD BPF (2011.10) | | | Tx SAW (Now) | | |
| | | | 28 | 25 | 24 | 28 | 25 | 24 |
| PA1 | 1850 | 2.7 | - | Not tested | | - | -139.5 | -139.5 |
| | | 3.4 | -139.7 | -139.2 | -139.4 | -139 | -139.2 | -139.2 |
| | 1880 | 2.7 | - | Not tested | | - | -143.7 | -143.5 |
| | | 3.4 | -138.6 | -141.5 | -141 | -142.9 | -142.8 | -143.1 |
| | 1910 | 2.7 | - | Not tested | | - | -143.9 | -144.5 |
| | | 3.4 | - | -140.5 | -141.3 | -140.2 | -143.6 | -143.9 |
| PA2 | 1850 | 2.7 | Not tested | | | - | -139.5 | -139.5 |
| | | 3.4 | | | | -139.1 | -139.2 | -139.3 |
| | 1880 | 2.7 | | | | - | -143.9 | -143.7 |
| | | 3.4 | | | | -143.2 | -142.9 | -143 |
| | 1910 | 2.7 | | | | - | -144 | -144.5 |
| | | 3.4 | | | | -140.7 | -143.7 | -143.9 |

The present disclosure further measures the receiving interference immunity of the mobile communication terminal, and the measurement result is as shown in Table 2:

Table 2:

| Project: Almond MT6276+MT6162+RF7242+SKY77559, No TX SAW filter Normal Voltage, Normal Temperature | | | |
| | CH9263 | CH9400 | CH9537 |
| TX:23dBm AWGN OFF | -109.5 | -110 | -109.5 |
| TX:-50dBm AWGN OFF | -109.5 | -110 | -109.5 |
| TX:-50dBm AWGN -97.2dBm@3.84MHz | -105 | -105.5 | -105.5 |
| TX:-50dBm AWGN -101.7dBm@3.84MHz | -107.5 | -107.5 | -107.5 |
| TX:-50dBm AWGN -105.7dBm@3.84MHz ATT=27 dB, RxNP=-144.5dBm/Hz, RxNp@Rx=171.5dBm/Hz | -108.5 | -109 | -109 |
| TX:-50dBm AWGN -107.2dBm@3.84MHz | -108.5 | -109 | -109 |
| TX:-50dBm AWGN -109.2dBm@3.84MHz | -108.5 | -109 | -109 |
| TX:-50dBm AWGN -111.2dBm@3.84MHz | -109 | -109 | -109 |
| TX:-50dBm AWGN -113.2dBm@3.84MHz | -109 | -109.5 | -109 |

(continued)

| Project: Almond MT6276+MT6162+RF7242+SKY77559, No TX SAW filter Normal Voltage, Normal Temperature | | | |
|---|---|---|---|
| | CH9263 | CH9400 | CH9537 |
| TX:-50dBm AWGN -115.2dBm@3.84MHz | -109 | -109.5 | -109 |
| TX:-50dBm AWGN -117.2dBm@3.84MHz | -109 | -109.5 | -109 |
| TX:-50dBm AWGN OFF | -109 | -109.5 | -109.5 |

As can be known from Table 2, if there is a high isolation degree between the transmitting antenna and the receiving antenna, that is, no additive white Gaussian noise (AWGN) is in the channel, the sensitivity of the high-, mid-, and low-channels are -109.5, -110, and -109.5 respectively.

If the isolation degree between the antennas is up to 27dB, the sensitivity of the high-, mid-, and low-channels are -107.5, -109, and -109 respectively under the noise condition of the power amplifier shown in Table 1.

If the isolation degree between the antennas is up to 27dB, the sensitivity of the high-, mid-, and low-channels are -105, -107.5, and -107.5 respectively under the noise condition of the power amplifier shown in Table 1. That is, the sensitivity thereof decreases by 4.5 dB, 2.5dB and 2.5 dB respectively.

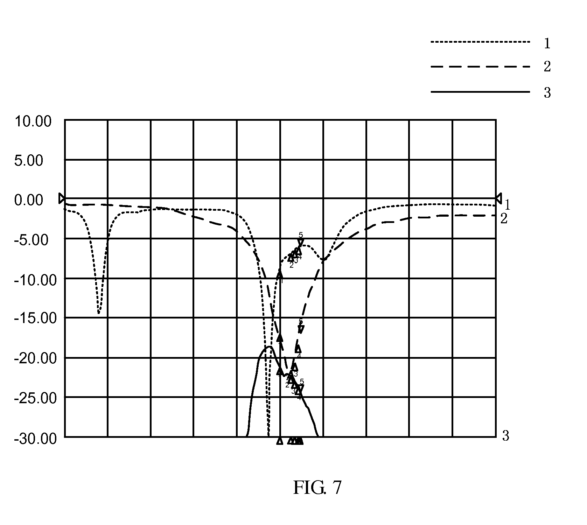

In light of the aforesaid experiment, the present disclosure carried out an experiment on the isolation degree between antennas. That is, a first antenna as shown in FIG. 6 is designed on the mobile communication terminal of the present disclosure. FIG. 6 is a partial schematic structural view illustrating the appearance of a first antenna of the mobile communication terminal according to the second embodiment of the present disclosure. As shown in FIG. 6, the first antenna 501 has a length of 19mm and a width of 12mm. The isolation degree between the receiving path and the transmitting path of the first antenna of FIG. 6 is as shown in FIG. 7.

Referring to FIG. 7, FIG. 7 is a graph illustrating the isolation degree between the receiving path and the transmitting path of the first antenna of the mobile communication terminal according to the second embodiment of the present disclosure. As shown in FIG. 7, the isolation degree between the receiving and the transmitting antennas is at least 23dB. Generally, the radiation sensitivity of the BC2 is -108dBm. With the isolation degree between antennas being 23dB, the radiation sensitivity of the high-, low-, and mid- channel can reach -103.5dBm, -105.5dBm, and -105.5dBm respectively according to the aforesaid sensitivity attenuation data. The aforesaid sensitivity can still ensure a very good call performance, and is merely the sensitivity at the maximum transmitting power. If the transmitting power is not so large, the noise to the receiving frequency band will decrease, so the sensitivity can reach a better level. As a result, an improvement in current as shown in Table 3 will be achieved.

Table 3:

| Medoc | Low(mA) | Mid(mA) | High(mA) |
|---|---|---|---|
| 23dBm output, original data | 510 | 480 | 480 |
| 23dBm output, PA 50ohm Load, without a duplexer | 370 | 360 | 360 |

As can be seen, an improvement in current of 140 mA at most can be obtained by the antenna architecture of the mobile communication terminal proposed by the present disclosure.

According to the above descriptions, the technical solution provided by the present disclosure disposes a first antenna and a second antenna, enables the first antenna to receive a high-band RF signal from the outside, enables the second antenna to transmit a to-be-transmitted high-band RF signal and a to-be-transmitted low-band RF signal, and enables the second antenna to receive the low-band RF signal. Accordingly, use of a high-frequency duplexer is omitted, so the insertion loss problem caused by the high-frequency duplexer is solved and, correspondingly, noises caused in the receiving frequency band by the transmitting path is reduced; and furthermore, the power consumption and the heat generation amount of the system are further decreased. Meanwhile, the radio frequency (RF) architecture is simplified, and a low-cost and more compact space can be obtained. The present disclosure is especially suitable for a platform having relatively low output power.

What described above are only the embodiments of the present disclosure, but are not intended to limit the scope of the present disclosure. Any equivalent structures or equivalent process flow modifications that are made according to the specification and the attached drawings of the present disclosure, or any direct or indirect applications of the present disclosure in other related technical fields shall all be covered within the scope of the present disclosure.

**Claims**

1. A mobile communication terminal, comprising:

 a first antenna, configured to receive a high-band radio frequency (RF) signal from the outside;
 a wireless transceiver, configured to acquire the high-band RF signal from the first antenna and generate a first base-band signal according to the high-band RF signal;
 a base-band processor, configured to acquire the first base-band signal from the wireless transceiver and modulate the first base-band signal, and further generate a second base-band signal and a third base-band signal for transmission to the wireless transceiver;
 the wireless transceiver being further configured to convert the second base-band signal into a to-be-transmitted high-band RF signal and convert the third base-band signal into a to-be-transmitted low-band RF signal;
 a second antenna, configured to acquire from the wireless transceiver and transmit the to-be-transmitted high-band RF signal and the to-be-transmitted low-band RF signal;
 wherein the second antenna is further configured to receive a low-band RF signal from the outside, the wireless transceiver is configured to acquire the low-band RF signal from the second antenna and generate a fourth base-band signal according to the low-band RF signal, and the base-band processor is configured to acquire the fourth base-band signal from the wireless transceiver and modulate the fourth base-band signal;
 a high-band RF signal power amplifier, disposed between the second antenna and the wireless transceiver and configured to amplify a power of the to-be-transmitted high-band RF signal generated by the wireless transceiver; and
 a low-band RF signal power amplifier, disposed between the second antenna and the wireless transceiver and configured to amplify a power of the to-be-transmitted low-band RF signal generated by the wireless transceiver.

2. The mobile communication terminal of claim 1, wherein the high-band RF signal comprises a BC1 signal and a BC4 signal, the low-band RF signal comprises a GSM HB signal and a GSM LB signal, the to-be-transmitted high-band RF signal comprises a BC1/BC4 signal and a BC2 signal, and the to-be-transmitted low-band RF signal comprises a to-be-transmitted GSM HB signal, a to-be-transmitted GSM LB signal and a to-be-transmitted BC5/BC8 signal.

3. The mobile communication terminal of claim 1, further comprising:

 a high-band RF signal reception surface acoustic wave (SAW) filter, disposed between the first antenna and the wireless transceiver and configured to perform a reception SAW filtering process on the high-band RF signal received by the first antenna; and
 a low-band RF signal reception SAW filter, disposed between the second antenna and the wireless transceiver and configured to perform the reception SAW filtering process on the low-band RF signal received by the second antenna.

4. A mobile communication terminal, comprising:

 a first antenna, configured to receive a high-band radio frequency (RF) signal from the outside;
 a wireless transceiver, configured to acquire the high-band RF signal from the first antenna and generate a first base-band signal according to the high-band RF signal;
 a base-band processor, configured to acquire the first base-band signal from the wireless transceiver and modulate the first base-band signal, and further generate a second base-band signal and a third base-band signal for transmission to the wireless transceiver;
 the wireless transceiver being further configured to convert the second base-band signal into a to-be-transmitted high-band RF signal and convert the third base-band signal into a to-be-transmitted low-band RF signal;
 a second antenna, configured to acquire from the wireless transceiver and transmit the to-be-transmitted high-band RF signal and the to-be-transmitted low-band RF signal;
 wherein the second antenna is further configured to receive a low-band RF signal from the outside, the wireless transceiver is configured to acquire the low-band RF signal from the second antenna and generate a fourth base-band signal according to the low-band RF signal, and the base-band processor is configured to acquire the fourth base-band signal from the wireless transceiver and modulate the fourth base-band signal.

**5.** The mobile communication terminal of claim 4, wherein the high-band RF signal comprises a BC1 signal and a BC4 signal, the low-band RF signal comprises a GSM HB signal and a GSM LB signal, the to-be-transmitted high-band RF signal comprises a BC1/BC4 signal and a BC2 signal, and the to-be-transmitted low-band RF signal comprises a to-be-transmitted GSM HB signal, a to-be-transmitted GSM LB signal and a to-be-transmitted BC5/BC8 signal.

**6.** The mobile communication terminal of claim 4, further comprising:

a high-band RF signal reception surface acoustic wave (SAW) filter, disposed between the first antenna and the wireless transceiver and configured to perform a reception SAW filtering process on the high-band RF signal received by the first antenna; and
a low-band RF signal reception SAW filter, disposed between the second antenna and the wireless transceiver and configured to perform the reception SAW filtering process on the low-band RF signal received by the second antenna.

**7.** The mobile communication terminal of claim 4, further comprising:

a high-band RF signal power amplifier, disposed between the second antenna and the wireless transceiver and configured to amplify a power of the to-be-transmitted high-band RF signal generated by the wireless transceiver.

**8.** The mobile communication terminal of claim 4, further comprising:

a low-band RF signal power amplifier, disposed between the second antenna and the wireless transceiver and configured to amplify a power of the to-be-transmitted low-band RF signal generated by the wireless transceiver.

**9.** A mobile communication terminal, comprising:

a first antenna, configured to receive a high-band radio frequency (RF) signal and a low-band RF signal from the outside;
a wireless transceiver, configured to acquire the high-band RF signal from the first antenna and generate a first base-band signal according to the high-band RF signal, and configured to acquire the low-band RF signal from the first antenna and generate a second base-band signal according to the low-band RF signal;
a base-band processor, configured to acquire the first base-band signal and the second base-band signal from the wireless transceiver and modulate the first base-band signal and the second base-band signal, and further generate a third base-band signal and a fourth base-band signal for transmission to the wireless transceiver;
the wireless transceiver being further configured to convert the third base-band signal into a to-be-transmitted high-band RF signal and convert the fourth base-band signal into a to-be-transmitted low-band RF signal;
a second antenna, configured to acquire from the wireless transceiver and transmit the to-be-transmitted high-band RF signal;
wherein the first antenna is further configured to acquire from the wireless transceiver and transmit the to-be-transmitted low-band RF signal.

**10.** The mobile communication terminal of claim 9, wherein the high-band RF signal comprises a BC1/BC4 signal, the low-band RF signal comprises a GSM 900/850 signal, a GSM DCS signal and a BC5/BC8 signal, the to-be-transmitted high-band RF signal comprises a BC1/BC4 signal and a BC2 signal, and the to-be-transmitted low-band RF signal comprises a to-be-transmitted GSM HB signal, a to-be-transmitted GSM LB signal and a to-be-transmitted BC5/BC8 signal.

**11.** The mobile communication terminal of claim 9, further comprising:

a high-band RF signal reception surface acoustic wave (SAW) filter, disposed between the first antenna and the wireless transceiver and configured to perform a reception SAW filtering process on the high-band RF signal received by the first antenna; and
a low-band RF signal reception SAW filter, disposed between the first antenna and the wireless transceiver and configured to perform the reception SAW filtering process on the low-band RF signal received by the first antenna.

**12.** The mobile communication terminal of claim 9, further comprising:

a high-band RF signal power amplifier, disposed between the second antenna and the wireless transceiver and configured to amplify a power of the to-be-transmitted high-band RF signal generated by the wireless transceiver.

13. The mobile communication terminal of claim 9, further comprising:

a low-band RF signal power amplifier, disposed between the first antenna and the wireless transceiver and configured to amplify a power of the to-be-transmitted low-band RF signal generated by the wireless transceiver.

FIG. 1

FIG. 2

FIG. 3

FIG. 4

FIG. 5

19mm

501

12mm

FIG. 6

FIG. 7

# INTERNATIONAL SEARCH REPORT

| International application No. |
| --- |
| PCT/CN2013/072239 |

## A. CLASSIFICATION OF SUBJECT MATTER

H04W 88/02 (2009.01) i

According to International Patent Classification (IPC) or to both national classification and IPC

## B. FIELDS SEARCHED

Minimum documentation searched (classification system followed by classification symbols)

IPC: H04W

Documentation searched other than minimum documentation to the extent that such documents are included in the fields searched

Electronic data base consulted during the international search (name of data base and, where practicable, search terms used)

CPRSABS, CNKI, CNTXT: dual-mode    multimode    high frequency    low frequency    mobile phone    antenna

DWPI, VEN: dual, multi+, mode, high, low, frequency, mobile, antenna

## C. DOCUMENTS CONSIDERED TO BE RELEVANT

| Category* | Citation of document, with indication, where appropriate, of the relevant passages | Relevant to claim No. |
| --- | --- | --- |
| P, X | CN 102684864 A (HUIZHOU TCL MOBILE COMMUNICATION CO., LTD.), 19 September 2012 (19.09.2012), claims 1-10 | 1-13 |
| X | CN 102404879 A (HUIZHOU TCL MOBILE COMMUNICATION CO., LTD.), 04 April 2012 (04.04.2012), claims 1-8 | 1-13 |
| A | CN 102332929 A (ZTE CORP.), 25 January 2012 (25.01.2012), the whole document | 1-13 |

☐ Further documents are listed in the continuation of Box C.    ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 25 May 2013 (25.05.2013) | 13 June 2013 (13.06.2013) |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer LI, Xiaoqian Telephone No.: (86-10) 62411287 |
| --- | --- |

Form PCT/ISA/210 (second sheet) (July 2009)

## INTERNATIONAL SEARCH REPORT
### Information on patent family members

| | International application No. |
| --- | --- |
| | **PCT/CN2013/072239** |

| Patent Documents referred in the Report | Publication Date | Patent Family | Publication Date |
| --- | --- | --- | --- |
| CN 102684864 A | 19.09.2012 | None | |
| CN 102404879 A | 04.04.2012 | WO 2013063915 A1 | 10.05.2013 |
| CN 102332929 A | 25.01.2012 | WO 2012152034 A1 | 15.11.2012 |

Form PCT/ISA/210 (patent family annex) (July 2009)